# EUROPÄISCHE PATENTSCHRIFT

(11) **EP 1 208 245 B1**
(45) Veröffentlichungstag und Bekanntmachung des Hinweises auf die Patenterteilung: **19.02.2003**
(21) Anmeldenummer: 00954559.1
(22) Anmeldetag: 25.07.2000
(51) Int. Cl.: C23C 16/56, C23C 16/24, C23C 16/515, H01L 31/04, H01L 21/205, H01L 31/075

(54) **PLASMA-CVD-VERFAHREN UND VORRICHTUNG ZUR HERSTELLUNG EINER MIKROKRISTALLINEN SI:H-SCHICHT**
PLASMA ACTIVATED CVD METHOD AND DEVICE FOR PRODUCING A MICROCRISTALLINE SI:H LAYER
PROCEDE CVD-PLASMA ET DISPOSITIF DE FABRICATION D'UNE COUCHE SI:H MICROCRISTALLINE

(30) Priorität: 26.07.1999 DE 19935046
(43) Veröffentlichungstag der Anmeldung: 29.05.2002
(73) Patentinhaber: Schott Glas, 55122 Mainz (DE)
(72) Erfinder: LOHMEYER, Manfred, D-55299 Nackenheim (DE); BAUER, Stefan, D-55286 Wörrstadt (DE); DANIELZIK, Burkhard, D-55128 Ingelheim (DE); MÖHL, Wolfgang, D-67550 Worms (DE); FREITAG, Nina, D-55578 Wallertheim (DE)
(86) Internationale Anmeldenummer: EP0007082
(87) Internationale Veröffentlichungsnummer: WO01007678

(56) Entgegenhaltungen:
- EP-A- 0 526 779
- EP-A- 0 919 643
- FR-A- 2 743 193
- US-A- 4 804 605

## Beschreibung

Die Erfindung betrifft ein Plasma-CVD-Verfahren und eine Vorrichtung zur Herstellung einer mikrokristallinen Si:H-Schicht auf einem Substrat sowie deren Verwendung, insbesondere deren Verwendung als Dünnschichtsolarzelle.

Eine Si:H-Schicht ist dabei eine Siliciumschicht in die Wasserstoff eingebaut ist. Der Wasserstoffanteil beträgt etwa 3 bis 20 %.

Solarzellen auf der Basis des Halbleitermaterials Silicium sind seit vielen Jahren bekannt. Diese Solarzellen werden meist aus massivem einkristallinem oder polykristallinem Silicium hergestellt, wobei typische Dicken einer solchen Solarzelle bei etwa 300 bis 500 µm liegen. Diese Dicken werden einerseits benötigt, um eine hinreichende mechanische Stabilität zu gewährleisten, andererseits, um eine möglichst vollständige Absorption des einfallenden Sonnenlichtes zu erhalten. Wegen der verhältnismäßig großen Schichtdicken und des damit verbundenen hohen Materialeinsatzes, sowie eines unvermeidlichen Hochtemperaturschrittes zur Dotierung der Siliciumscheiben (T ≥ 1000 °C) sind solche Solarzellen mit einer kostenintensiven Herstellung verbunden.

Alternativ zu diesen relativ dicken o.g. Silicium-Solarzellen, haben sich neben den bereits seit etwa 20 Jahren erforschten Dünnschichtsolarzellen auf der Basis von amorphem Si:H (im folgenden a-Si:H genannt) in den letzten Jahren Dünnschichtsolarzellen aus mikrokristallinem Si:H (im folgenden µc-Si:H genannt) als Untersuchungsobjekt etabliert. Man erwartet von diesem Zellenmaterial einen ähnlich hohen Wirkungsgrad, vergleichbar mit dem von einkristallinem Silicium, jedoch verbunden mit kostengünstigeren Produktionsprozessen, wie man sie auch von a-Si:H kennt. Allerdings soll durch die Verwendung von µc-Si:H die, bei der Verwendung von a-Si:H, unvermeidliche Degradation des Wirkungsgrades bei intensiver Beleuchtung unterdrückt werden. Der kommerziellen Nutzung von µc-Si:H als funktionelle Schicht in einer Dünnschichtsolarzelle stehen aber zur Zeit noch einige wesentliche Punkte entgegen. Im Gegensatz zur Solarzelle mit a-Si:H, die eine Dicke der photovoltaisch aktiven Schicht von etwa 300 nm aufweist, muß die Solarzelle aus µc-Si:H, um eine ähnlich gute Ausnutzung des einfallenden Lichtes zu gewährleisten etwa 3000 nm, d.h. einen Faktor 10 dicker sein. Ein wirtschaftlicher Prozeß muß daher auch eine um etwa diesen Faktor höhere Abscheiderate des mikrokristallinen Materials gegenüber a-Si:H ermöglichen. Als weiteres notwendiges Merkmal für eine kommerzielle Nutzung der µc-Si:H-Schichten erscheint eine preiswerte Substratunterlage als unverzichtbar, vorzugsweise Fensterglas oder sogar Standard-Kunststoffe. Dazu müssen zu diesen Substraten kompatible Abscheideverfahren, d.h. Niedrigtemperatur-Prozesse (T < 100 °C für Kunststoff bzw. T ≤ 200 bis 300 °C für Glas, das mit einer transparenten leitfähigen Schicht versehen ist) zur Verfügung stehen, die zudem noch hohe Schichterzeugungsraten bieten.

Mikrokristallines Silicium (µc-Si:H) kann nach dem Stand der Technik bei Temperaturen größer als etwa 200 °C mit unterschiedlichen Verfahren in dünnen Schichten auf einem Trägerrnaterial aufgebracht werden. Beispielsweise kann es direkt aus der Gasphase abgeschieden werden. Bekannt sind z.B. folgende Abscheidemethoden: Hochfrequenz-Glimmentladungs-Abscheidung (HF-PECVD), Elektron-Zyklotron-Resonanz (ECR)-Verfahren, Elektron-Zyklotron-Wellen-Resonanz (ECWR)-Verfahren, Sputter-Deposition, Hot-Wire-Technik (HW), Mikrowellen-CVD.

Weiterhin sind auch Verfahren bekannt, bei denen µc-Si:H dadurch hergestellt wird, daß zunächst a-Si:H aus der Gasphase abgeschieden wird, das dann anschließend in µc-Si:H umgewandelt wird. Die Transformation von a-Si:H zu µc-Si:H ist beispielsweise aus folgenden Schriften bekannt.

So wird in der US 5,470,619 die Umwandlung von a-Si:H in µc-Si:H mittels Wärmebehandlung bei einer Temperatur von 450 °C bis 600 °C beschrieben.

Die US 5,486,237 beschreibt eine temperaturinduzierte Umwandlung von a-Si:H-Schichten in µc-Si:H-Schichten bei 550 °C bis 650 °C über einen Zeitraum von 3 bis 20 Stunden.

In den US 5,344,796 wird ein Verfahren zur Herstellung einer dünnen µc-Si:H-Schicht auf einem Glassubstrat beschrieben. Dabei wird auf dem Substrat zuerst eine µc-Si:H-Schicht erzeugt, die als Keimschicht dient, auf diese Keimschicht wird mittels eines CVD-Verfahrens a-Si:H deponiert. Mittels Wärmebehandlung, bevorzugt zwischen 580 °C und 600 °C über einen Zeitraum von 20 bis 50 Stunden, wird das a-Si:H in µc-Si:H umgewandelt.

Die US 5,693,957 beschreibt ebenfalls die thermische Umwandlung von a-Si:H-Schichten in µc-Si:H-Schichten bei 600 °C, wobei durch Verunreinigung von bestimmten a-Si:H-Schichten deren Umwandlung in µc-Si:H gezielt verhindert wird.

Ein Mikrowellen-Plasma-CVD-Verfahren zur Herstellung von a-Si:H und µc-Si:H-Schichten wird in der Schrift US 5,334,423 beschrieben, wobei im Sättigungsmodus 100 % der Mikrowellenleistung eingebracht wird.

In der WO 93/13553 wird ein Mikrowellen-CVD-Verfahren zur Herstellung von dünnen Halbleiterschichten beschrieben, wobei der Prozeßdruck unterhalb des Paschenminimums liegt. Ein Mikrowellen-CVD-Verfahren mit steuerbarem Bias-Potential zur Herstellung von dünnen Halbleiterschichten wird in der Schrift US 5,204,272 beschrieben.

Die Herstellung von µc-Si:H -Schichten mittels eines Mikrowellen-CVD-Verfahrens wird im US-Patent 4,891,330 beschrieben, wobei dem Prozeß- oder Precursorgas bevorzugt wenigstens 67 % Wasserstoff zugesetzt wird, um die Bildung der µc-Si:H-Phase zu unterstützen.

Ein Plasma-Verfahren zur Herstellung einer µc-Si:H-Schicht wird in der Schrift WO 97/24769 beschrieben, wobei das Precursorgas mit Wasserstoff und/oder Argon verdünnt wird.

Des weiteren wird eine Plasmabehandlung einer a-Si:H-Schicht mittels eines Argonplasmas in der US-Schrift 4,762,803 und mittels eines Wasserstoffplasmas in der WO-Schrift 93/10555 beschrieben, um eine µc-Si:H-Schicht zu erhalten.

Aus der EP 05 71 632 A1 ist ein Plasma-CVD-Verfahren zur Herstellung einer mikrokristallinen Si:H-Schicht auf einem Substrat bekannt. Hierzu wird zuerst auf dem Substrat eine dünne amorphe Si:H-Schicht durch plasmagestützte CVD-Beschichtung hergestellt. Sodann wird die amorphe Si:H-Schicht einer plasmagestützten Behandlung mit einem Wasserstoffplasma unterworfen, wobei die amorphe Si:H-Schicht in die mikrokristaline Si:H-Schicht umgewandelt wird.

Eine plasmagestützte CVD-Beschichtung im Impuls-Modus zum Herstellen einer amorphen Si:H-Schicht auf einem Substrat ist aus der US 5,618,758 bekannt.

Weiterhin ist es auch möglich eine µc-Si:H-Schicht durch alternierende Abscheidung von a-Si:H Schichten und anschließende Behandlung dieser Schicht mit einem Wasserstoffplasma herzustellen. Dieses Verfahren wird in der Literatur meist als Layer-by-layer (LBL) Technik bezeichnet. Der atomistische Prozeß der Umwandlung des a-Si:H zu µc-Si:H ist bis heute nicht eindeutig geklärt (es sind mehrere Modelle in der Diskussion), jedoch ist ein Konkurrenzprozeß zwischen Abätzen ungünstiger Si-Si-Bindungen und wasserstoffinduzierter Restrukturierung des Netzwerkes zur energetisch günstigeren kristallinen Phase sehr wahrscheinlich.

Für die Abscheidung der a-Si:H-Schicht werden häufig solche Parameter verwendet, die gute, d.h. bauelement-taugliche a-Si:H-Schichten liefern. Die in der Literatur berichteten Dicken der Einzelschichten liegen typischerweise zwischen 1,4 und mehreren 10 nm. Wegen dieser relativ großen Schichtdickenvariation resultieren daraus Nachbehandlungszeiten mit einem H₂-Plasma, die im Bereich von einigen Sekunden bis zu mehreren Minuten liegen. Als Abscheideverfahren werden HF-PECVD Verfahren eingesetzt, wobei wegen der niedrigen Anregungsfrequenz, die Abscheideraten vergleichsweise klein sind.

HF-PECVD-Verfahren erreichen maximal effektive Abscheideraten (tatsächlich abgeschiedene Schichtdicke dividiert durch dazu notwendige Zeit), die deutlich unter 10 nm/min liegen.
Nachfolgend sind Literaturstellen angegeben, die den Stand der Technik der µc-Si:H-Abscheidung mittels der LBL-Technik repräsentieren:
- Asano, A.; Appl. Phys. Lett. 56 (1990) 533;
- Jin Jang; Sung Ok Koh; Tae Gon Kim; Sung Chul Kim, Appl. Phys. Lett. 60 (1992)2874;
- Otobe, M.; Oda, S.; Jpn. J. Appl. Phys. 31 (1992) 1948;
- Kyu Chang Park, Sung Yi Kim; Min Park; Jung Mok Jun; Kyung Ha Lee; Jin Jang; Solar Energy Materials and Solar Cells, Vol.34 (1994), 509;
- Hapke, P.; Carius, R.; Finger, F.; Lambertz, A.; Vetterl, O.; Wagner, H.; Material Research Society Symposium Proceedings, Vol.452; (1997), 737.

Alle bisher für die LBL-Technik eingesetzten Verfahren liefern sehr kleine effektive Abscheideraten (1 - 6 nm/min), die restriktiv auf eine kommerzielle Nutzung wirken. Bei den bisher eingesetzten LBL-Verfahren können des weiteren die Einzelschichtdicken (1 nm bis einige 10 nm) ohne aufwendige in-situ Meßtechnik nicht zuverlässig genau eingestellt werden. Diese Unschärfe aus dem 1. Schritt des Verfahrens wird in den 2. Schritt übertragen. Daraus resultiert insbesondere, daß die Dauer des 2. Schrittes (H₂-Plasmabehandlung) nicht präzise voraus bestimmbar ist. Damit ist der Prozeß von einer inhärenten Stabilität abhängig, die bei einer technischen Umsetzung nicht erreicht werden kann.

Maßnahmen zur Ratenerhöhung, z.B. durch eine erhöhte Leistungseinkopplung (höhere Plasmadichten) führen zu einer Erhöhung des Partikelanteiles in der Schicht und damit zu einer Qualitätsverminderung.

Es werden in der Literatur und den genannten Schriften relativ hohe Prozeßtemperaturen (250 - 330 °C) beschrieben, die offenbar notwendig sind, um ausreichende Schichtqualitäten (kompakte, d.h. dichte Schichten) zu erreichen und um die Schichthaftung sicherzustellen. Damit sind thermolabile Substrate nicht beschichtbar.

Ausgehend hiervon liegt der vorliegenden Erfindung die Aufgabe zugrunde, ein Plasma-CVD-Verfahren und eine Plasma-CVD-Vorrichtung zur Herstellung einer mikrokristallinen Si:H-Schicht auf einem Substrat bereitzustellen, wobei die mikrokristalline Si:H-Schicht durch Behandlung einer amorphen Si:H-Schicht mit einem Wasserstoffplasma hergestellt wird. Dabei soll eine hochwertige mikrokristalline Si:H-Schicht auf einem Substrat, kostengünstig mit hohen Depositionsraten hergestellt werden. Schichtdicke und -zusammensetzung sollen kontrolliert einstellbar und regelbar sein, die Herstellung soll unter möglichst geringer Erwärmung des Substrates erfolgen.

Zur Lösung dieser Aufgabe wird nach Anspruch 1 erfindungsgemäß ein Plasma-CVD-Verfahren zur Herstellung einer mikrokristallinen Si:H-Schicht auf einem Substrat, mit den Schritten:
1.1 plasmagestützte-CVD-Beschichtung wenigstens einer dünnen amorphen Si:H-Schicht auf dem Substrat,
1.2 plasmagestützte Behandlung der amorphen Si:H-Schicht mit einem Wasserstoffplasma, wobei die amorphe Si:H-Schicht in eine mikrokristalline Si:H-Schicht umgewandelt wird und
1.3 gegebenenfalls Wiederholung der Schritte 1.1 und 1.2.,
vorgeschlagen, das dadurch gekennzeichnet ist, daß die Beschichtung bzw. die Behandlung bei einem kontinuierlichen Fluß der Beschichtungsgase bzw. der Behandlungsgase und bei gepulster elektromagnetischer Strahlung, die das Plasma anregt, durchgeführt wird.

Bezüglich der Vorrichtung wird die Aufgabe gemäß Anspruch 23 dadurch gelöst, daß eine Vorrichtung zur Herstellung einer mikrokristallinen Si:H-Schicht auf einem Substrat mit einem Plasma-CVD-Verfahren bereitgestellt wird, wobei auf den inneren Oberflächen der Vorrichtung, insbesondere auf den inneren Oberflächen der Depositionskammer, eine amorphe Si:H-Schicht pulsinduziert deponiert ist.

Plasma-Impuls-CVD-Verfahren sind bekannt und beispielsweise in Journal of the Ceramic Society of Japan, 99 (10), 894-902 (1991) beschrieben. Bei diesen Verfahren wird in der Regel bei kontinuierlichem Fluß der Beschichtungsgase die das Plasma anregende elektromagnetische Strahlung gepulst zugeführt, wobei sich bei jedem Impuls eine dünne Schicht (typisch ≥ 0,1 nm) auf das Substrat niederschlägt. Dadurch, daß jedem Leistungsimpuls eine Impulspause folgt, können selbst nicht-temperaturstabile Substrate während eines Impulses mit hohen Leistungen beaufschlagt werden. Hierdurch sind insbesondere hohe Beschichtungsgeschwindigkeiten ohne nennenswerte Temperaturbelastung des Substrates möglich.

Das erfindungsgemäße Plasma-CVD-Verfahren ermöglicht daher erstmals eine sehr schnelle, kostengünstige Herstellung hochwertiger, mikrokristalliner Si:H-Schichten auf einem Substrat. Die Schichtdicke sowie die Zusammensetzung der Si:H-Schicht sind reproduzierbar einstellbar und regelbar. Die Herstellung der Schicht erfolgt unter sehr geringer Erwärmung des Substrats.

Vorzugsweise wird die amorphe Si:H-Schicht in einzelnen Schichtpaketen deponiert, wobei pro Puls Schichtpakete aus 1 bis 50, besonders aus 1 bis 5 a-Si:H-Monolagen hergestellt werden können.

Die Schichtdicke eines Schichtpaketes ist dabei reproduzierbar einstellbar. Bei ansonsten konstanten Bedingungen wird pro Puls immer eine bestimmte Schichtdicke an a-Si:H deponiert. Durch einfaches Zählen der Pulse läßt sich so ein Vielfaches der Schichtdicke eines Schichtpaketes einstellen. Die Schichtdicke eines Schichtpakets kann hierzu einmalig experimentell bestimmt werden.

Mit vorgegebener bzw. einstellbarer Schichtdicke der a-Si:H-Schicht ist auch die pulsinduzierte Behandlungsdauer mit dem Wasserstoffplasma einfach experimentell vorbestimmbar und damit genau definiert.

Nach jedem Impuls und damit Abscheiden eines a-Si:H-Schichtpaketes erfolgt bevorzugt ein sehr schneller Wechsel des Beschichtungsgases, d. h. das Gas wird abgeführt und ein neues Beschichtungsgas in die Depositionskammer geleitet.

Die ersten auf das Substrat aufgebrachten Schichtlagen werden bevorzugt in Form einer degressiven Gradientenführung mit erhöhtem, inhärentem mikrokristallinem Si:H-Anteil deponiert. Ein bevorzugtes Verfahren zur Herstellung einer Gradientenschicht wird dabei in der DE 44 45 427 C2 beschrieben. Dadurch, daß die erste Schicht bereits einen gewissen Anteil an µc-Si:H aufweist, erfolgt die spätere Umwandlung von a-Si:H zu µc-Si:H wesentlich schneller und einfacher, weil die Kristallinformation in den ersten Schichtlagen vorliegt.

Damit wird die Herstellung weiterer Gradientenschichten überflüssig. Da diese Prozedur sehr zeitintensiv und aufwendig ist, wird nach der einmaligen Herstellung einer µc-Si:H enthaltenden Gradientenschicht das Verfahren so umgestellt, daß anschließend nur noch a-Si:H deponiert und zu µc-Si:H umgewandelt wird.

Es wird bevorzugt jeweils eine 0,1 bis 5 nm dünne amorphe Si:H-Schicht deponiert und anschließend in µc-Si:H umgewandelt, wobei eine Pulsdauer eines Pulses der elektromagnetischen Strahlung von ≥ 0,1 ms und eine Pulspause der elektromagnetischen Strahlung - also der Pause zwischen zwei Pulsen - von ≤ 200 ms eingestellt wird.

Die Behandlungszeit mit dem gepulsten Wasserstoffplasma wird bevorzugt auf bis zu 30 Sekunden, insbesondere auf bis zu 10 Sekunden eingestellt.

Insgesamt wird dabei eine bis zu 5000 nm dicke mikrokristalline Si:H-Schicht auf dem Substrat hergestellt, größere Dicken sind ohne Einschränkungen möglich.

Der PICVD-Prozeß läßt sich mit Wechselspannungsimpulsen einer Frequenz zwischen etwa 50 kHz und 300 GHz durchführen. Besonders geeignet wegen der hohen Beschichtungsgeschwindigkeit und der Möglichkeit, in einem vergleichsweise breiten Druckbereich (0,001 bis etwa 10 mbar) zu arbeiten, sind Mikrowellenfrequenzen; unter diesen ist die 2,45 GHz-Frequenz als Industriefrequenz bevorzugt, weil die entsprechenden Mikrowellenbauteile leicht zu beschaffen und preisgünstig sind. Das Impulsverfahren bietet als weiteren Vorteil die Möglichkeit, den Impuls selbst zu formen und dadurch Eigenschaften der durch einen einzigen Plasmaimpuls abgeschiedenen dünnen Schicht in Schichtwachstumsrichtung noch weiter zu beeinflussen. Bei einem Druck von 0,1 - 2 mbar, einer Anregungsfrequenz von 2,45 GHz haben sich insbesondere Impulsdauern zwischen 0,1 und 2 ms und Impulspausen zwischen 5 und ≤ 200 ms als geeignet zur Herstellung der erfindungsgemäßen Schichttypen erwiesen. Wenn die Reaktionszeiten im Plasma sehr klein sind, können Impulsdauem von 0,01 ms sinnvoll sein; die Verwendung so kurzer Impulse ist jedoch oft durch apparative Begrenzungen (Impulsanstiegszeit) beschränkt. Der empfohlene Bereich für die Impulshöhe läßt sich nicht in Zahlen angeben; der Minimalwert ist der Wert, bei dem gerade noch bei dem betreffenden Beschichtungsgas und den übrigen Prozeßparametem die Entladung gezündet werden kann, der Maximalwert ist gegeben durch die Leistungsfähigkeit des gerade verwendeten Impulsgenerators.

Zur Herstellung der Gradientenschicht wird man in der Regel so vorgehen, daß man in einer Vorversuchsreihe die Abhängigkeit der Schichteigenschaften bzw. -zusammensetzungen von Impulsdauer, -höhe und -pause ermittelt und bei der eigentlichen Herstellung der Gradientenschicht dies Parameter so steuert, daß in Schichtwachstumsrichtung der gewünschte Gradient entsteht. Die Genauigkeit, mit der der Gradient vorher festgelegt werden muß, richtet sich nach den Anforderungen an die Schicht. Es ist mit dem erfindungsgemäßen Verfahren ohne Schwierigkeiten möglich, beispielsweise die Zusammensetzung der Schicht auf dem Substrat in Schichtwachstumsrichtung von Monolage zu Monolage zu ändern.

Bevorzugt wird eine mittlere Mikrowellenleistung von 150 mW/cm³ bis 1500 mW/cm³ eingesetzt.

Die amorphe Si:H-Schicht wird vorzugsweise aus einem Beschichtungsgas, das wenigstens einen Si-organischen Schichtbildner enthält, deponiert, wobei als Beschichtungsgas ein Silan, insbesondere SiH₄ oder ein Chlorsilan eingesetzt und ein Prozeßdruck im Bereich von 0,1 bis 1 mbar eingestellt wird. Selbst bei hohen Abscheideraten, d. h. relativ hohem Prozeßdruck und hoher Pulsleistung, wurde wider Erwarten keine Staub- oder Pulverbildung in der Schicht beobachtet.

Besonders vorteilhaft ist es, wenn das Beschichtungsgas nach jeder a-Si:H-Schicht sehr schnell gewechselt wird. Durch sehr schnelle Gasaustauschzeiten (< 10 ms) wird das Verfahren besonders wirtschaftlich und es lassen sich reproduzierbar µc-Si:H-Schichten mit einstellbarer Dicke und Qualität herstellen.

Dem Beschichtungsgas kann Wasserstoff zugesetzt werden.

Vorzugsweise wird das erfindungsgemäße Verfahren derart geführt, daß die Substrattemperatur 200 °C, insbesondere 100 °C und besonders bevorzugt 50 °C nicht überschreitet.

Nach den erfindungsgemäßen Verfahren ist es mit Vorteil möglich, Leitfähigkeiten der µc-Si:H-Schicht von 10⁻⁷ S/cm bis 10 S/cm einzustellen, wobei die Leitfähigkeiten gegebenenfalls durch Dotierung mit Fremdatomen, beispielsweise über das Beschichtungsgases, eingestellt werden.

Bevorzugt wird dabei eine n-, p- oder nicht dotierte µc-Si:H-Schicht hergestellt. Insbesondere zur Herstellung von Dünnschichtsolarzellen ist es notwendig, mehrere, unterschiedliche, übereinanderliegende µc-Si:H-Schichten auf einem Substrat herzustellen.

Als Substrat wird bevorzugt ein Glas, eine Glaskeramik oder ein Kunststoff verwendet, wobei das Substrat besonders bevorzugt mit einer transparenten leitfähigen Schicht , insbesondere einer ITO-Schicht, einer dotierten SnO₂-Schicht oder einer dotierten ZnO-Schicht versehen ist.

Eine nach dem erfindungsgemäßen Verfahren hergestellte µc-Si:H-Schicht auf einem Substrat findet bevorzugt Verwendung als Bestandteil einer Dünnschichtsolarzelle oder als Bestandteil eines Dünnschichttransistors (TFT).

Das folgende Ausführungsbeispiel und die Zeichnungen sollen die Erfindung näher erläuteren:
Es zeigen:
   - Fig. 1:: einen Schichtaufbau bestehend aus einzelnen Schichtpaketen Si:H auf einem Substrat mit plasmagestützer Behandlung mit einem Wasserstoffplasma und
   - Fig. 2:: eine Detaildarstellung der ersten auf einem Substrat in Form einer degressiven Gradientenführung aufgebrachten Schichtlage Si:H.

Eine erfindungsgemäße Vorrichtung zur Herstellung einer µc-Si:H-Schicht auf einem Substrat mit einem Plasma-CVD-Verfahren wurde derart vorkonditioniert, daß auf den inneren Oberflächen der Depositionskammer (Reaktor) eine a-Si:H-Schicht pulsinduziert deponiert wurde. Die Depositionskammer wurde dabei mit einer a-Si:H-Schicht belegt, die mehrere 10 nm, vorzugsweise einige 100 nm umfaßt.

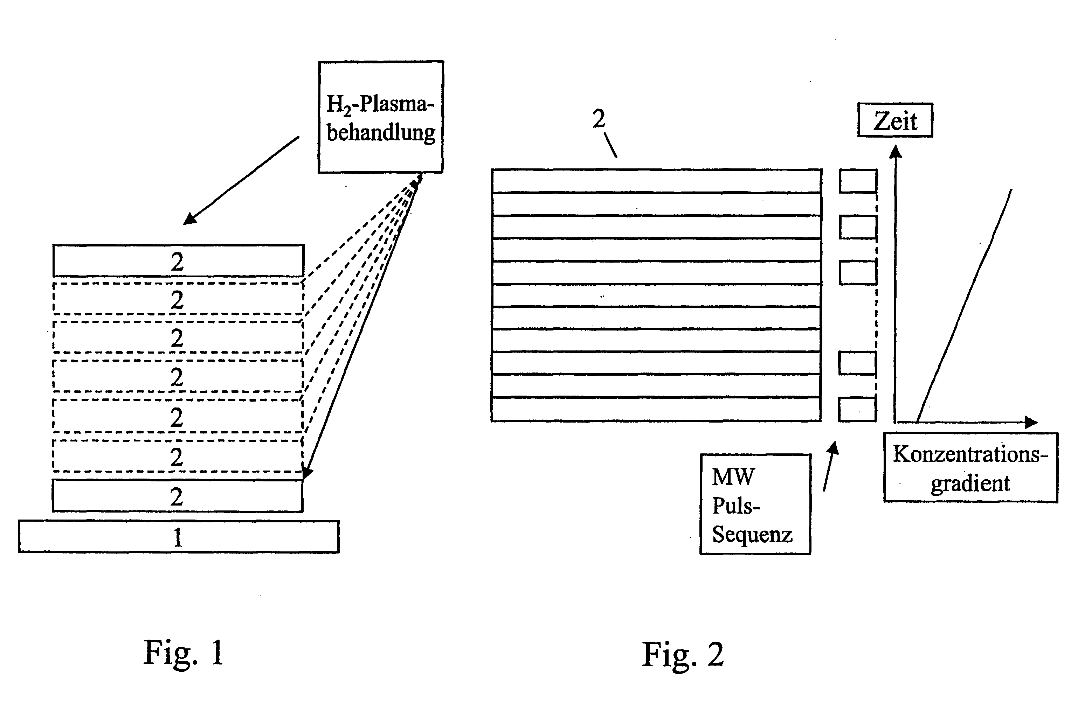

Mit einem typischen Prozeßdruck von 0,1 - 1 mbar wurden alternierend a-Si:H-Schichten (2) aus einem siliciumwasserstoffhaltigen Precursorgas, vorzugsweise einem Silan, insbesondere Monosilan (SiH₄) - mit oder ohne Wasserstoffverdünnung - als 0,1 bis 5 nm dünne Schicht auf einem Substrat (1) (Figur 1) abgeschieden. Die Dauer der Wasserstoffplasma-Behandlung kann maximal 30 sec, vorzugsweise 10 sec, insbesondere 5 sec betragen. Für die Abscheidung der a-Si:H-Schicht sowie für die anschließende Behandlung der Schicht mit dem Wasserstoffplasma wurde eine gepulste Mikrowelle (2,45 GHz) eingesetzt. Durch diese Mikrowellen-Pulstechnik ist es möglich, die Schichtdicke aufgrund einer genau kontrollierten Pulsfolge (Pulsdauer ≥ 0,1 ms; Pulspause ≤ 200 ms) exakt einzustellen (die Abscheidung erfolgt quasi in Monolagen). Die mittlere Mikrowellenleistung überstreicht dabei einen Bereich von ca. 150 mW/cm³ bis etwa 1500 mW/cm³. Der gepulste Betrieb der Mikrowelle führt einerseits zu einer deutlich geringeren Temperaturbelastung des Substrats als bei gleicher mittlerer Leistung im kontinuierlichen Mikrowellenbetrieb. Andererseits wird eine deutlich schnellere Abscheidung der a-Si:H-Schichtpakete bei hoher Schichtqualität erreicht. Mit Hilfe extrem schneller Gaswechsel können sehr kurze Einzelprozeßzeiten erreicht werden, wodurch die effektive Rate, die sich aus dem Quotienten der Gesamtschichtdicke zur Beschichtungszeit für die gesamte a-Si:H-Schicht plus der aufgewendeten Zeit für die Wasserstoffplasma-Behandlung berechnet, mit ca. 10 - 80 nm/min mindestens eine Größenordnung höher liegt als bisher in der Literatur angegeben. Die Substrattemperatur kann dabei zwischen 25 °C und 400 °C liegen. Wider

Erwarten kann also auch bei T < 100 °C, insbesondere bei T < 50 °C eine kompakte Schicht guter Qualität hergestellt werden, wobei damit die Möglichkeit gegeben ist, insbesondere auch auf temperaturempfindlichen Kunststoffsubstraten (z.B. PE) µc-Si:H-Schichten (2) mit dem erfindungsgemäßen Verfahren abzuscheiden.

Figur 2 zeigt in Detaildarstellung die erste auf das Substrat aufgebrachte .Schichtlage (2), die in Form einer degressiven Gradientenführung mit erhöhtem, inhärentem mikrokristallinem Si:H-Anteil deponiert wurde.

Die Schichtbildner-Konzentration nimmt dabei mit zunehmender Zeit und Impulszahl zu. Der Verlauf der Schlchtbildner-Konzentration (Konzentrationsgradient) gegen die Zeit und in Abhängigkeit von der Impulszahl (Mikrowellen-Pulssequenz) ist rechts in Figur 2 dargestellt.

Das Wasserstoff-Plasma in einem vorkonditionierten Reaktor bewirkt dabei zwei wichtige Effekte: Einerseits wird die µc-Si:H-Phase bevorzugt gebildet und im weiteren führt der parallel laufende Ätzeffekt zu einem Abtrag von unerwünschten Schichten auf dem Mikrowellen-Fenster und den übrigen inneren Reaktoroberflächen. Damit wirkt das Wasserstoff-Plasma positiv auf die erstrebte Materialmodifikation verbunden mit einer Reinigungswirkung auf den Reaktor. Damit können deutlich längere Wartungsintervalle eingeführt werden, die sich positiv auf eine technische Umsetzbarkeit auswirken.

Man hat im Laufe der Zeit unterschiedliche Modellvorstellungen zur Bildung von µc-Si:H entwickelt. Im sog. "Ätzmodell" (engl. etching model') geht man davon aus, daß durch das Plasma gebildeter atomarer Wasserstoff an der aufwachsenden Schichtoberfläche bevorzugt schwache Si-Si Bindungen aufbricht und Siliciumatome im Netzwerk ersetzt werden, so daß letztlich die kristalline Phase (stärkere Bindungen) gegenüber der amorphen Phase dominiert. Das sog. Modell der "chemischen Ausheilung" (chemical annealing) trägt der Tatsache Rechnung, daß bei geeigneter Wahl der Abscheideparameter keine Schichtdickenänderung während der Phase der Wasserstoffplasma-Behandlung beobachtet wird. In der Modellvorstellung dringt atomarer Wasserstoff in eine Wachstumszone unterhalb der Schichtoberfläche ein und fördert dort die Bildung eines flexiblen Netzwerks, d.h. eine Umorganisation des Netzwerks zugunsten der kristallinen Phase, ohne daß Siliciumbindungen weggeätzt werden.

Beim erfindungsgemäßen Verfahren wird der Bildungsprozeß der mikrokristallinen Si:H-Phase sehr wahrscheinlich dadurch beeinflußt, daß das Wasserstoffplasma, welches auf die zuvor abgeschiedene amorphe Si:H-Schicht einwirkt, eine nahezu vollständige Belegung der zuvor abgeschiedenen amorphen Schicht bewirkt. Die Wasserstoffbedeckung der Oberfläche führt einerseits durch die Absättigung freier Valenzen und andererseits durch die Bereitstellung von Rekombinationsenergie zu einer drastischen Erhöhung der Oberflächendiffusionskonstante der schichtbildenden Teilchen. Dadurch wird es möglich, daß diese Teilchen energetisch günstige Plätze einnehmen können, was zur Bildung kristalliner Bereiche (Keime) und nachfolgend zu einer vollständigen Kristallisation mehrerer Monolagen führt.

Die so erzeugten Schichten zeichnen sich durch eine hohe Kristallinität sowie eine gute Absättigung der Komgrenzen zwischen den einzelnen Kristalliten aus. Durch die Ausbildung von Keimschichten (Mischphase mit erhöhtem inhärenten µc-Si:H Anteil), erzeugt in den ersten Atom-Lagen, wird die Transformationsrate (a-Si:H zu µc-Si:H) deutlich erhöht. Dies wird erfindungsgemäß durch das gezielte Führen eines Ratengradienten erreicht. Ein präzises Steuern des genannten Gradienten ist nur durch den gepulsten Modus der Mikrowelle möglich, denn nur dadurch lassen sich Frischgas- und Abgaseinflüsse auf die Schichtbildung trennen und Gasmischungen bzw. Konzentrationsverhältnisse gezielt einstellen. Der Pulsmodus der Mikrowelle erlaubt es darüber hinaus hohe Spitzenleistungen einzusetzen und damit hohe Abscheideraten zu gewinnen. Dabei wird nicht beobachtet, daß die Schichtbildung durch Partikeleinbau in ihrer Qualität herabgesetzt wird. Offenbar spielen hier elektrostatische Einflüsse aus der Plasmagrenzschicht eine große Rolle; der Pulsmodus unterdrückt die Partikelbildung auch bei hohen Spitzenleistungen. Als Folge davon wird eine wirtschaftliche Anwendung dieser Schichten in elektronischen Bauelementen, insbesondere in Solarzellen erst vertretbar.

## Patentansprüche

1. Plasma-CVD-Verfahren zur Herstellung einer mikrokristallinen Si:H-Schicht auf einen Substrat mit den Schritten:
1.1 plasmagestützte-CVD-Beschichtung wenigstens einer dünnen amorphen Si:H-Schicht auf dem Substrat,
1.2 plasmagestützte Behandlung der amorphen Si:H-Schicht mit einem Wasserstoffplasma, wobei die amorphe Si:H-Schicht in eine mikrokristalline Si:H-Schicht umgewandelt wird und
1.3 gegebenenfalls Wiederholung der Schritte 1.1 und 1.2
**dadurch gekennzeichnet,**
**daß** die Beschichtung bzw. die Behandlung bei einem kontinuierlichen Fluß der Beschichtungsgase bzw. der Behandlungsgase und bei gepulster elektromaghetischer Strahlung, die das Plasma anregt, durchgeführt wird.

2. Verfahren nach Anspruch 1,
**dadurch gekennzeichnet,**
**daß** jeweils eine aus 1 bis 50 amorphen Si:H-Monolagen bestehende amorphe Si:H-Schicht deponiert wird.

3. Verfahren nach Anspruch 2,
**dadurch gekennzeichnet,**
**daß** die ersten auf das Substrat aufgebrachten Schichtlagen in Form einer degressiven Gradientenführung mit erhöhtem, inhärentem mikrokristallinem Si:H-Anteil deponiert werden.

4. Verfahren nach wenigstens einem der Ansprüche 1 bis 3,
**dadurch gekennzeichnet,**
**daß** jeweils eine 0,1 bis 5 nm dünne amorphe Si:H-Schicht deponiert und umgewandelt wird.

5. Verfahren nach wenigstens einem der Ansprüche 1 bis 4,
**dadurch gekennzeichnet,**
**daß** eine Behandlungsdauer mit dem gepulsten Wasserstoffplasma von bis zu 30 Sekunden, insbesondere von bis zu 10 Sekunden eingestellt wird.

6. Verfahren nach wenigstens einem der Ansprüche 1 bis 5,
**dadurch gekennzeichnet,**
**daß** eine Pulsdauer eines Pulses der elektromagnetischen Strahlung von ≥ 0,1 ms eingestellt wird.

7. Verfahren nach wenigstens einem der Ansprüche 1 bis 6,
**dadurch gekennzeichnet,**
**daß** eine Pulspause zwischen zwei Pulsen der elektromagnetischen Strahlung von ≤ 200 ms eingestellt wird.

8. Verfahren nach wenigstens einem der Ansprüche 1 bis 7,
**dadurch gekennzeichnet,**
**daß** insgesamt eine bis zu 5000 nm dicke mikrokristalline Si:H-Schicht auf dem Substrat hergestellt wird.

9. Verfahren nach wenigstens einem der Ansprüche 1 bis 8,
**dadurch gekennzeichnet,**
**daß** das Plasma mittels Mikrowellenstrahlung angeregt wird.

10. Verfahren nach Anspruch 9,
**dadurch gekennzeichnet,**
**daß** eine Anregungsfrequenz der Mikrowellenstrahlung von 2,45 GHz eingesetzt wird.

11. Verfahren nach Anspruch 8 oder 10,
**dadurch gekennzeichnet,**
**daß** eine mittlere Mikrowellenleistung von 150 mW/cm³ bis 1500 mW/cm³ eingesetzt wird.

12. Verfahren nach wenigstens einem der Ansprüche 1 bis 11,
**dadurch gekennzeichnet,**
**daß** die amorphe Si:H-Schicht aus einem Beschichtungsgas, das wenigstens einen Si-organischen Schichtbildner enthält, deponiert wird.

13. Verfahren nach Anspruch 12,
**dadurch gekennzeichnet,**
**daß** als Beschichtungsgas ein Silan, insbesondere SiH₄ oder ein Chlorsilan eingesetzt wird.

14. Verfahren nach Anspruch 12 oder 13,
**dadurch gekennzeichnet,**
**daß** dem Beschichtungsgas Wasserstoff zugesetzt wird.

15. Verfahren nach wenigstens einem der Ansprüche 1 bis 14,
**dadurch gekennzeichnet,**
**daß** ein Prozeßdruck von 0,1 bis 1 mbar eingestellt wird.

16. Verfahren nach wenigstens einem der Ansprüche 1 bis 15,
**dadruch gekennzeichnet,**
daß nach jeder amorphen Si:H-Schicht das Beschichtungsgas sehr schnell gewechselt wird.

17. Verfahren nach wenigstens einem der Ansprüche 1 bis 16,
**dadurch gekennzeichnet,**
**daß** die Substrattemperatur während der Verfahrensführung 200 °C, vorzugsweise 100 °C, insbesondere 50 °C nicht überschreitet.

18. Verfahren nach wenigstens einem der Ansprüche 1 bis 17,
**dadurch gekennzeichnet,**
**daß** Leitfähigkeiten der mikrokristallinen Si:H-Schicht von 10⁻⁷ S/cm bis 10 S/cm eingestellt werden.

19. Verfahren nach wenigstens einem der Ansprüche 1 bis 18,
**dadurch gekennzeichnet,**
**daß** ein Substrat aus einem Glas, einer Glaskeramik oder einem Kunststoff verwendet wird.

20. Verfahren nach Anspruch 19,
**dadurch gekennzeichnet,**
**daß** das Substrat mit einer transparent leitfähigen Schicht versehen ist.

21. Verfahren nach Anspruch 20,
**dadurch gekennzeichnet,**
**daß** die transparent leitfähige Schicht eine ITO-Schicht, eine dotierte SnO₂-Schicht oder eine dotierte ZnO-Schicht ist.

22. Vorrichtung zur Herstellung einer mikrokristallinen Si:H-Schicht auf einem Substrat mit einem Plasma-CVD-Verfahren nach wenigstens einem der Ansprüche 1 bis 21,
**dadurch gekennzeichnet,**
**daß** auf den inneren Oberflächen der Vorrichtung, insbesondere auf den inneren Oberflächen der Depositionskammer, vor Beginn der Herstellung der mikrokristallinen Si:H-Schicht eine amorphe Si:H-Schicht deponiert ist.

23. Verwendung einer nach wenigstens einem der Anspüche 1 bis 21 hergestellten mikrokristallinen Si:H-Schicht auf einem Substrat als Bestandteil einer Dünnschichtsolarzelle.

24. Verwendung einer nach wenigstens einem der Anspüche 1 bis 21 hergestellten mikrokristallinen Si:H-Schicht auf einem Substrat als Bestandteil eines Dünnschichttransistors (TFT).

## Claims

1. Plasma CVD process for the production of a microcrystalline Si:H film on a substrate, comprising the following steps:
1.1 plasma-enhanced CVD coating of the substrate with at least one thin amorphous Si:H film,
1.2 plasma-enhanced treatment of the amorphous Si:H film using a hydrogen plasma, the amorphous Si:H film being transformed into a microcrystalline Si:H film, and
1.3 repeating the steps 1.1 and 1.2 if necessary
**characterized in that** the coating or the treatment is carried out with a continuous flow of the coating gases or the treatment gases and using pulsed electromagnetic radiation which excites the plasma.

2. Process according to Claim 1, **characterized in that** an amorphous Si:H film in each case comprising 1 to 50 amorphous Si:H monolayers is deposited.

3. Process according to Claim 2, **characterized in that** the first film layers which are applied to the substrate are deposited in the form of a degressive gradient with an elevated, inherent microcrystalline Si:H fraction.

4. Process according to at least one of Claims 1 to 3, **characterized in that** a thin amorphous Si:H film which is in each case 0.1 to 5 nm thick is deposited and transformed.

5. Process according to at least one of Claims 1 to 4, **characterized in that** a treatment duration with the pulsed hydrogen plasma of up to 30 seconds, in particular of up to 10 seconds, is set.

6. Process according to at least one of Claims 1 to 5, **characterized in that** a duration of a pulse of the electromagnetic radiation of ≥ 0.1 ms is set.

7. Process according to at least one of Claims 1 to 6, **characterized in that** a pause between two pulses of the electromagnetic radiation of ≤ 200 ms is set.

8. Process according to at least one of Claims 1 to 7, **characterized in that** overall a microcrystalline Si:H film which is up to 5000 nm thick is produced on the substrate.

9. Process according to at least one of Claims 1 to 8, **characterized in that** the plasma is excited by means of microwave radiation.

10. Process according to Claim 9, **characterized in that** an excitation frequency of the magnetic radiation of 2.45 GHz is used.

11. Process according to Claim 8 or 10, **characterized in that** a mean microwave power of 150 mW/cm³ to 1500 mW/cm³ is used.

12. Process according to at least one of Claims 1 to 11, **characterized in that** the amorphous Si:H film is deposited from a coating gas which contains at least one Si-organic film-forming agent.

13. Process according to Claim 12, **characterized in that** the coating gas used is a silane, in particular SiH₄ or a chlorosilane.

14. Process according to Claim 12 or 13, **characterized in that** hydrogen is added to the coating gas.

15. Process according to at least one of Claims 1 to 14, **characterized in that** a process pressure of from 0.1 to 1 mbar is set.

16. Process according to at least one of Claims 1 to 15, **characterized in that** the coating gas is changed very quickly after each Si:H film.

17. Process according to at least one of Claims 1 to 16, **characterized in that** the substrate temperature during the process does not exceed 200°C, preferably 100°C, in particular 50°C.

18. Process according to at least one of Claims 1 to 17, **characterized in that** conductivities of the microcrystalline Si:H film of from 10⁻⁷ S/cm to 10 S/cm are set.

19. Process according to at least one of Claims 1 to 18, **characterized in that** a substrate made from a glass, a glass ceramic or a plastic is used.

20. Process according to Claim 19, **characterized in that** the substrate is provided with a transparent, conductive film.

21. Process according to Claim 20, **characterized in that** the transparent, conductive film is an ITO film, a doped SnO₂ film or a doped ZnO film.

22. Device for producing a microcrystalline Si:H film, on a substrate using the plasma CVD process according to at least one of Claims 1 to 21, **characterized in that**, before production of the microcrystalline Si:H film commences, an amorphous Si:H film is deposited on the inner surfaces of the device, in particular on the inner surfaces of the deposition chamber.

23. Use of a microcrystalline Si:H film on a substrate which has been produced as described in at least one of Claims 1 to 21 as a component of thin-film solar cell.

24. Use of a microcrystalline Si:H film on a substrate which has been produced as described in at least one of Claims 1 to 21 as a component of a thin-film transistor (TFT).

## Revendications

1. Procédé de CVD par plasma pour la fabrication d'une couche microcristalline de Si:H sur un substrat, comportant les étapes suivantes:
1.1 application par CVD assisté par plasma d'au moins une mince couche amorphe de Si:H sur le substrat,
1.2 traitement assisté par plasma de la couche amorphe de Si:H par un plasma d'hydrogène, la couche amorphe de Si:H étant convertie en une couche microcristalline de Si:H, et
1.3 éventuellement, répétition des étapes 1.1 et 1.2,
**caractérisé en ce que** le revêtement ou le traitement est exécuté sous un flux continu de gaz de revêtement ou de gaz de traitement et avec un rayonnement électromagnétique pulsé qui excite le plasma.

2. Procédé selon la revendication 1, **caractérisé en ce que** chaque fois une couche amorphe de Si:H constituée de 1 à 50 monocouches amorphes de Si:H est déposée.

3. Procédé selon la revendication 2, **caractérisé en ce que** les premières couches appliquées sur le substrat sont déposées sous la forme d'un guidage à gradient dégressif avec une proportion croissante de Si:H microcristallin intrinsèque.

4. Procédé selon au moins l'une des revendications 1 à 3, **caractérisé en ce que** chaque fois une mince couche amorphe de Si:H d'une épaisseur de 0,1 à 5 nm est déposée et convertie.

5. Procédé selon au moins l'une des revendications 1 à 4, **caractérisé en ce que** l'on règle une durée de traitement par le plasma pulsé d'hydrogène de jusque 30 secondes, en particulier de jusque 10 secondes.

6. Procédé selon au moins l'une des revendications 1 à 5, **caractérisé en ce que** l'on règle la durée d'une impulsion du rayonnement électromagnétique à ≥ 0,1 ms.

7. Procédé selon au moins l'une des revendications 1 à 6, **caractérisé en ce que** l'on règle entre deux impulsions du rayonnement électromagnétique une pause de ≤ 200 ms.

8. Procédé selon au moins l'une des revendications 1 à 7, **caractérisé en ce que** l'on réalise sur le substrat en tout une couche microcristalline de Si:H d'une épaisseur pouvant atteindre 5 000 nm.

9. Procédé selon au moins l'une des revendications 1 à 8, **caractérisé en ce que** le plasma est excité par un rayonnement à micro-ondes.

10. Procédé selon la revendication 9, **caractérisé en ce qu'**on utilise une fréquence d'excitation du rayonnement à micro-ondes de 2,45 GHz.

11. Procédé selon la revendication 8 ou 10,
**caractérisé en ce que** l'on utilise une densité moyenne de micro-ondes de 150 mW/cm³ à 1 500 mW/cm³.

12. Procédé selon au moins l'une des revendications 1 à 11, **caractérisé en ce que** la couche amorphe de Si:H est déposée à partir d'un gaz de revêtement qui contient au moins un agent organique au Si de formation de couche.

13. Procédé selon la revendication 12, **caractérisé en ce que** l'on utilise comme gaz de revêtement un silane, en particulier le SiH₄ ou un chlorosilane.

14. Procédé selon la revendication 12 ou 13, **caractérisé en ce que** l'on ajoute de l'hydrogène au gaz de revêtement.

15. Procédé selon au moins l'une des revendications 1 à 14, **caractérisé en ce que** l'on règle une pression de traitement de 0,1 à 1 mbar.

16. Procédé selon au moins l'une des revendications 1 à 15, **caractérisé en ce qu'**après chaque couche amorphe de Si:H, le gaz de revêtement est remplacé très rapidement.

17. Procédé selon au moins l'une des revendications 1 à 16, **caractérisé en ce que** pendant la conduite du procédé, la température du substrat ne dépasse pas 200°C, de préférence 100°C et en particulier 50°C.

18. Procédé selon au moins l'une des revendications 1 à 17, **caractérisé en ce que** la conductivité de la couche microcristalline de Si:H est réglée entre 10⁻⁷ S/cm et 10 S/cm.

19. Procédé selon au moins l'une des revendications 1 à 18, **caractérisé en ce qu'**on utilise un substrat constitué d'un verre, d'une céramique vitreuse ou d'une matière synthétique.

20. Procédé selon la revendication 19, **caractérisé en ce que** le substrat est doté d'une couche conductrice transparente.

21. Procédé selon la revendication 20, **caractérisé en ce que** la couche conductrice transparente est une couche de ITO, une couche dopée de SnO₂ ou une couche dopée de ZnO.

22. Dispositif pour la fabrication d'une couche microcristalline de Si:H sur un substrat par un procédé de CVD par plasma selon au moins l'une des revendications 1 à 21,
**caractérisé en ce qu'**avant la fabrication de la couche microcristalline de Si:H, une couche amorphe de Si:H est déposée sur les surfaces intérieures du dispositif, en particulier sur les surfaces intérieures de la chambre de dépôt.

23. Utilisation d'une couche microcristalline de Si:H sur un substrat, fabriquée selon au moins l'une des revendications 1 à 21, comme composant d'une cellule solaire à couche mince.

24. Utilisation d'une couche microcristalline de Si:H sur un substrat, fabriquée selon au moins l'une des revendications 1 à 21, comme composant d'un transistor à couche mince (TFT).
